Europäisches Patentamt

European Patent Office

Office européen des brevets

(11) Veröffentlichungsnummer: **0 103 655**
**B1**

(12) **EUROPÄISCHE PATENTSCHRIFT**

(45) Veröffentlichungstag der Patentschrift: **11.02.87**

(21) Anmeldenummer: **82108769.9**

(22) Anmeldetag: **22.09.82**

(51) Int. Cl.⁴: **G 01 N 27/76, G 01 R 33/16**

(54) **Anordnung zur Bestimmung der Eigenschaften magnetischer Partikeldispersionen.**

(43) Veröffentlichungstag der Anmeldung:
**28.03.84 Patentblatt 84/13**

(45) Bekanntmachung des Hinweises auf die
Patenterteilung:
**11.02.87 Patentblatt 87/07**

(84) Benannte Vertragsstaaten:
**DE FR GB IT**

(56) Entgegenhaltungen:
**FR-A-1 104 436**

**JOURNAL OF PHYSICS. E. SCIENTIFIC
INSTRUMENTS; Band 12, Nr. 6, Juni 1979
London G. ZIBOLD et al. "Apparatus for the
measurement of the initial susceptibility of
quench-condensed spin glass films", Seiten
490-494**

**JOURNAL OF PHYSICS.E. SCIENTIFIC
INSTRUMENTS, Band 14, Nr. 10, Oktober 1981,
Dorking M.P. COOKE et al. "A radio frequency
method for the measurement of initial
magnetic susceptibility", Seiten 1192-1196**

(73) Patentinhaber: **IBM DEUTSCHLAND GMBH
Pascalstrasse 100
D-7000 Stuttgart 80 (DE)**
(84) **DE**
(73) Patentinhaber: **International Business Machines
Corporation
Old Orchard Road
Armonk, N.Y. 10504 (US)**
(84) **FR GB IT**

(72) Erfinder: **Brunsch, Arwed, Dr. Dipl.-Phys.
Am Bopserweg 8
D-7000 Stuttgart 1 (DE)**
Erfinder: **Steiner, Werner
Zeisigweg 17/1
D-7030 Böblingen (DE)**
Erfinder: **Trippel, Gerhard, Dr. Dipl.-Phys.
Steinenbronnerstrasse 15
D-7032 Sindelfingen (DE)**

(74) Vertreter: **Herzog, F. Joachim, Dipl.-Ing et al
Schönaicher Strasse 220
D-7030 Böblingen (DE)**

Courier Press, Leamington Spa, England.

## Beschreibung

Die Erfindung bezieht sich auf eine Anordnung zur Bestimmung der Eigenschaften von magnetischen Beschichtungsmassen, die aus einer Dispersion von Magnetpartikeln, insbesondere $\gamma$-$Fe_2O_3$-Pigment in einer flüssigen Harz-Lösungsmittel-Mischung bestehen.

Partikulare magnetische Beschichtungsmassen sind weitverbreitet zur Herstellung vom magnetischen Aufzeichnungsträgern, wie insbesondere Magnetplatten und Magnetbänder. Nach dem Aufbringen der magnetischen Beschichtungsmasse auf den Träger verdunstet der größte Teil des Lösungsmittels. Bei bzw. nach dem Aufbringen der Beschichtungsmasse und dem Verdunsten des Lösungsmittels erfolgt ein Orientieren der Magnetpartikel, das Einbrennen und Polieren des Aufzeichnungsträgers, ggf. ein Schmieren der Oberfläche und letztlich ein Test auf die magnetischen Eigenschaften des Aufzeichnungsträgers hin. Für die Güte des mangetischen Aufzeichnunsträgers von entscheidender Bedeutung ist die Güte der magnetischen Beschichtungsmasse.

Die magnetische Beschichtungsmasse wird im allgemeinen unter Benutzung von Verfahren der Farbherstellung hergestellt. Dabei ist neben der präzisen Einhaltung der chemischen Zusammensetzung ein komplizierter mechanischer Bearbeitungsprozeß von großer Wichtigkeit. Dieser und die physikalisch-chemischen Eigenschaften der Bestandteile der Beschichtungsmasse sowie ihre gegenseitige Wirkung bestimmen die innere Struktur der Beschichtungsmasse wobei der Dispersionsgrad und der Grad der Aggolomeration der einzelnen Partikel eine entscheidende Rolle spielen.

Für diese Eigenschaften, die in hohem Maße die Qualität des fertigen Aufzeichnungsträgers beeinflussen, existieren bislang keine direkten Meßmöglichkeiten. Die Viskosität der Beschichtungsmasse, die stark von der inneren Struktur abhängt, beeinflußt die Verarbeitbarkeit. Elektrostatische und magnetostatische Kräfte zwischen den Partikeln können zu Alterungserscheinungen führen, die erst später im fertigen Aufzeichnungsträger sichtbar werden.

Die Qualität und Güte der Beschichtungsmasse wird zur Zeit in der Produktion dadurch überprüft, daß ein Kontrollaufzeichnungsträger hergestellt wird, der im wesentlichen einem fertigen Aufzeichnungsträger entspricht und daß dann dessen Qualität überprüft wird. Von dieser Überprüfung wird die weitere Verwendung der Beschichtungsmasse abhängig gemacht. Es ist einleuchtend, daß eine derartige Überprüfung zeitaufwendig, kostspielig und ungenau ist, da unmittelbar vor und während dem Auftragen der Beschichtungsmasse auf dem Träger keine Aussage üger den Zustand der Beschichtungsmasse möglich ist.

Wesentliche Eigenschaften für die Güte der magnetischen Beschichtungsmasse sind der Dispersionsgrad bzw. der Agglomerationsgrad, die Partikeldichte und die Viskosität. Darüber hinaus spielt die Stabilität der Masse eine Rolle, die stark von der Zeit abhängig ist, d.h. wie stabil ist die Beschichtungsmasse während einer gewissen Zeitspanne oder anders ausgedrückt, altert die Beschichtungsmasse frühzeitig und im welchem Maß.

Aus dem Stand der Technik gemäß der DE—PS 17 98 223 ist ein Verfahren zur kontinuierlichen Kontrolle der Homogenisierung von Gemischen aus zwei oder mehreren Stoffen bekannt. Dazu wird dem zu homogenisierenden Gemisch als Indikator ein pulverartiger magnetisch orientierter Stoff zugesetzt. Mit Hilfe eines im Gerät untergebrachten Meßgerätes wird die Intensität des Magnetfeldes verfolgt. Bei diesem Verfahren wird die makroskopische Dispersion des Indikators in dem Gemische verfolgt, im dem die magnetische Dichte gemessen wird. Dieses Verfahren sagt jedoch nichts über die Mikroskopische Verteilung und den Zustand der einzelnen Partikel aus.

Aus der DE—OS 20 49 463 ist ein Verfahren zur Dispersionsanalyse von Suspensionen bekannt. Dabei wird der Dispersionsgrad der Suspension nach der maximalen Schichtdicke eines mittels eines Schabers auf eine Unterlage verteilten Suspension beurteilt, wobei die Unterlage kontinuierlich unter dem Schaber in einer Richtung hindurchgedrecht wird. Bei diesem Verfahren ist nachteilig, daß zur Kontrolle laufend Suspension entnommen werden muß, und daß es darüber hinaus sehr schwierig ist, eine notwendige sehr geringe Keilschichtdicke von wenigen µm herzustellen.

Aus der DE—PS 23 37 165 ist ein Verfahren und eine Vorrichtung zur Messung des elektrokinetischen Zeta-Potentials einer Dispersion bekannt. Aus der zu untersuchenden Dispersion wird kontinuierlich ein Probenstrom entnommen und durch eine Trennzelle geschickt, in der der Probenstrom einem Magnetfeld ausgesetzt und in mehrere Teilströme zerlegt wird. Diese Teilströme werden dann durch einzelne separate Meßzellen geleitet, in denen der Feststoffgehalt der einzelnen Teilströme kontinuierlich bestimmt wird. Mit der Messung gemäß diesem Verfahren wird die elektrostatische Aufladung der Pigmente in Bezug auf das Harzbindesystem bestimmt und die Stabilität der Dispersion, nicht aber deren Dispersionsgrad charakterisiert.

In der DE—OS 29 29 018 ist eine Einrichtung für die Messung der Aggregation von Parktikeln mit einer Wand oder untereinander beschirieben, wobei die Partikel in einer Flüssigkeits- oder Gasströmung dispergiert sind. Das flüssige oder gasförmige Mehrphasensystem wird auf eine durchsichtige Wand gerichtet und beleuchtet. Das gestruete, reflektierte oder durch Absorption geschwächte Licht wird auf einen Detektor gerichtet und ausgewertet. Die Messung der Aggregation der Partikel untereinander oder an der Wand funktioniert nur bei stark verdünnten Dispersionen, die durchsichtig sind. Sie ist nicht geeignet für hochkonzentrierte Dispersionen, wie dies üblicherweise magnetische Beschichtungsmassen sind, weil diese undurchsichtig sind.

Die Aufgabe vorliegender erfindung besteht darin, für die Messung der eine magnetische Partikeldispersion charakterisierenden Eigenschaften ein eindeutiges Verfahren bzw. Anordnung anzugeben, die darüber hinaus geeignet ist, Basis für eine Kontinuierliche Messung und Überwachung der magnetischen Eigenschaften der Beschichtungsmasse zu sein. Die Lösung dieser Aufgabe sieht bei der Anordnung wie sie in den Ansprüchen gekennzeichnet ist, im Kern so aus, daß die Beschichtungsmasse einem von einer Generatoranordnung erzeugtem magnetischen Wechselfeld variabler Frequenz aussetzbar ist, das vom magnetischen Wechselfeld induzierte Signal durch eine Aufnehmeranordnung aufnehmbar ist und die Suszeptibilität in Abhängigkeit der variablen Frequenz meßbar ist und hinsichtlich Dispersionsgrad, Partikeldichte und Viskosität der Beschichtungsmasse auswertbar ist.

Die mit der Erfindung erzielten Vorteile bestehen im wesentlichen darin, daß über die Güte der Beschichtungsmasse hinsichtlich der Eingenschaften Dispersionsgrad, Partikeldichte und Viskosität eine direkte Aussage möglich ist. -

Damit ist auch die Basis gegeben, diese Anordnung zur kontinuierlichen Überwachung der Eigenschaften und der Güte der Beschichtungsmasse während deren Herstellung und Verarbeitung vorzunehmen.

Vorteilhafte Ausgestaltungen und Weiterbildungen der im Anspruch 1 angegebenen Prinzipiellen Lehre zum technischen Handeln sind in den abhängigen Ansprüchen niedergelegt. Die damit erzielbaren Vorteile ergeben sich dabei als von selbst auf der Hand liegend oder werden an entsprechender Stelle in der nachfolgenden beschreibung erläutert.

Im folgenden wird die Erfindung anhand einer lediglich einen Ausführungsweg darstellenden Zeichnung näher erläutert. Es zeigt

Fig. 1 schematisch ein Blockschaltbild einer ersten Ausführungsform der erfindungsgemäßen Anordnung;

Fig. 2 schematisch die Suszeptibilät in Abhängigkeit von der Frequenz für verschiedene Eigenschaftskonstellationen;

Fig. 3 schematisch ein Blockschaltbild einer zweiten Ausführungsform der erfindungsgemäßen Anordnung und

Fig. 4 schematisch den Einbau der erfindungsgemäßen Anordnung in die Bypass-Leitung eines vorratsgefäßes für die Beschichtungsmasse.

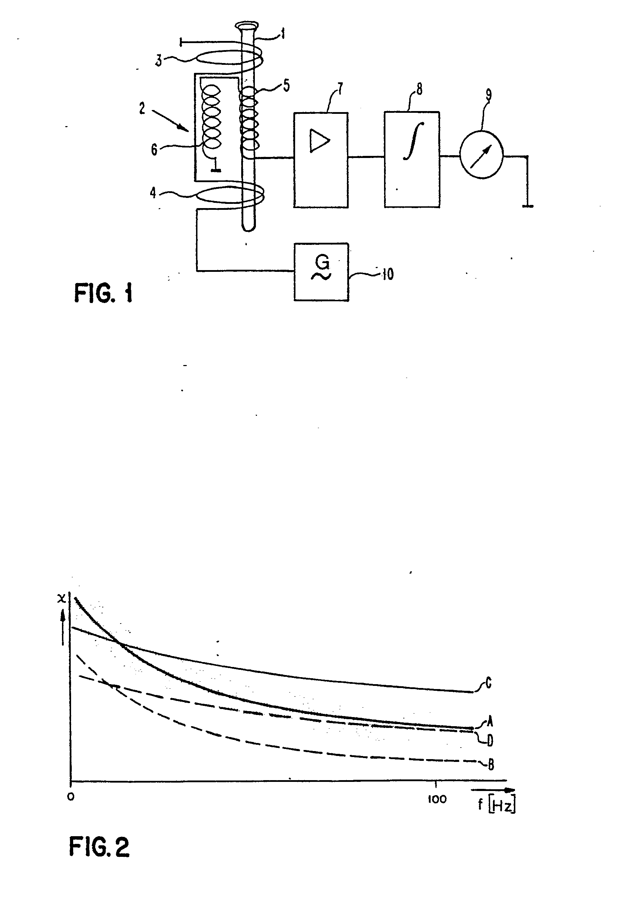

Fig. 1 zeigt im Blockschaltbild eine erste Ausführungsform Gemäß der Erfindung. Die zu untersuchende Beschichtungsmasse ist in einem Gefäß 1, welches einem Reagenzglas ähnlich sein kann, untergebracht. Dieses Gefäß 1 wird mit seiner Beschichtungsmasse in eine Spulenanordnung 2 gebracht. Die Spulenanordnung 2 besteht aus zwei Feldspulen 3 und 4, die das erregende magnetische Wechselfeld erzeugen und beispielsweise ein sog. Helmholtz-Spulenpaar bilden können. Die Spulenanordnung 2 umfaßt weiterhin eine Meßspule 5 und eine Kompensationsspule 6. Dabei ist die Kompensationsspule 6 mit der Meßspule 5 indentisch, jedoch nicht von dem Gefäß 1 mit der zu untersuchenden Beschichtungsmasse durchsetzt. Die beiden Spulen 5 und 6 sind vorzugsweise symmetrisch in die Feldkonfiguration eingebracht, die von den beiden Spulen 3 und 4 generiert wird. Dadurch ist sichergestellt, daß der einfluß des erregenden Feldes der Spulen 3 und 4 durch die Kompensationsspule 6 einfach aus dem Meßergebnis eliminiert werden.

Die Meßspule 5 ist einerseits mit der Kompensationsspule 6 verbunden und andererseits mit einem Verstärker 7, der das gemessene Signal verstärkt, einem Integrator 8 zuführt, an dessen Ausgang mit Hilfe eines Voltmeters 9 das Meßergebnis angezeigt wird.

Die beiden Feldspulen 3 und 4 werden von einem Funktionsgenerator 10 gespeist, der den Spulen einen Sinusförmigen Strom veränderbarer Frequenz zuführt, um ein magnetisches Wechselfeld variabler Frequenz zwischen den Beiden Spulen 3 und 4 zu erzeugen, dem die zu untersuchende Beschichtungsmasse in dem Gefäß ausgesetzt ist.

Die Beschichtungsmasse reagiert entsprechend ihrer Zusammensetzung und induziert ein Signal in der Meßspule 5. In der Kompensationsspule 6 wird nur das Signal des Feldes zwischen den Spulen 3 und 4 induziert, so daß dem Verstärker 7 nur dasjenige Meßsignal zugeführt wird, das über die von der beschichtungsmasse beeinglußte Spannung auskunft gibt. Diese Spannung stellt die Suszeptibilität der Beschichtungsmasse dar und wird im Verstärker 7 verstärkt, im Integrator 8 integriert und schließlich auf dem Spannungsmesser 9 angezeigt.

Die Frequenz des magnetischen Wechselfeldes wird mittels des Generators 10 zwischen etwa 1 und 100 H geändert und jeweils nacheinander durchfahren. Dabei wird die Zeit, in der der Generator kontinuierlich von der Frequenz 1 Hz bis zur Frequenz 100 Hz durchfahren wird, so eingestellt, daß jede Frequenz zumindest solange ansteht, daß ein induziertes Signal, welches dieser Frequenz entspricht in der Meßspule 5 ankommt. In der Praxis kann dazu ein Zeitraum von etwa 10 Sek. Ausreichend sein, in der der Bereich von 1 Hz bis 100 Hz durchfahren wird und dann erneut durchfahren werden kann. Die Messung wird in dem Frequenzbereich zwischen 1 und 100 Hz bei möglichst kleinen Feldern durchgeführt. Die Feldstärke, die von dem vom Funktionsgenerator 10 gelieferten Strom mittels der Spulen 3 und 4 erzeugt wird, soll so klein sein, daß die Feldgradienten am Ende der Spulen 3 und 4 keine unerwünschte magnetostatisch bedingte Koagulation der Teilchen der Beschichtungsmasse bewirken, es soll also die Beschichtungsmasse nicht verändert werden. Andererseits muß die Feldstärke groß genug sein, damit in der Meßspule 5 ein von der Beschichtungsmasse induziertes Signal auftritt und meßbar ist. Die Fledstärke wird vorzugsweise kleiner als 10 Oerstedt (800 A/m) gewählt.

Für sehr verdünnte Teilchensysteme, d.h. für solche Systeme die so wenig Partikel enthalten,

daß diese untereinander ohne gegenseitige Wechselwirkungen sind, läßt sich zeigen, daß aus der Messung der Suszeptibilität sowie des Phasenwinkels zwischen dem erregenden Feld der Spulen 3 und 4 und dem in der Meßspule 5 induzierten Feld Rückschlüsse auf die Teilchendichte, den Dispersionsgrad und auf die Viskosität der Beschichtungsmasse gezogen werden Können.

Bei den in der Magnetiplattentechnologie üblichen sehr hohen Teilchendichte lassen sich solche Abhängigkeiten jedoch nur empirisch ermitteln. In Fig. 2 sind in den Kurven A bis D verschiedene Verläufe der Suszeptibilität in Abhängigkeit von der Frequenz f dargestellt. So zeigt die voll ausgezogene Kurve A den Verlauf der Suszeptibilität $\chi$ über der Frequenz f für eine Beschichtungsmasse, die in ihren magnetischen Eigenschaften innerhalb der gewünschten Grenzen liegt und somit den Normalfall darstellt. Oberhalb und unterhalb der Kurve ist gepunktet der Toleranzbereich angegeben. Die gestrichelte Kurve B, die im gesamten Bereich im wesentlichen parallel zur Kurve A verläuft und niedrigere Werte für die Suszeptibilität $\chi$ und damit die Magnetisierung der Suspensions angibt, besagt, daß die Beschichtungsmasse zu wenig Partikel enthält. Die Kurve C, die im Bereich niedrigerer Frequenzen unterhalb der Normalkurve A und im Bereich höherer Frequenzen, etwa ab 15 bis 20 Hz, oberhalb der Normalkurve A verläuft, besagt, daß die Suspension eine zu geringe Viskosität aufweist. Die Kurve D, die im Bereich niedrigerer Frequenzen stark und im Bereich höherer Frequenzen nur geringfügig unterhalb der Normalkurve A verläuft, sagt aus, daß die zugehörige Beschichtungsmasse einen zu schlechten Dispersionsgrad aufweist.

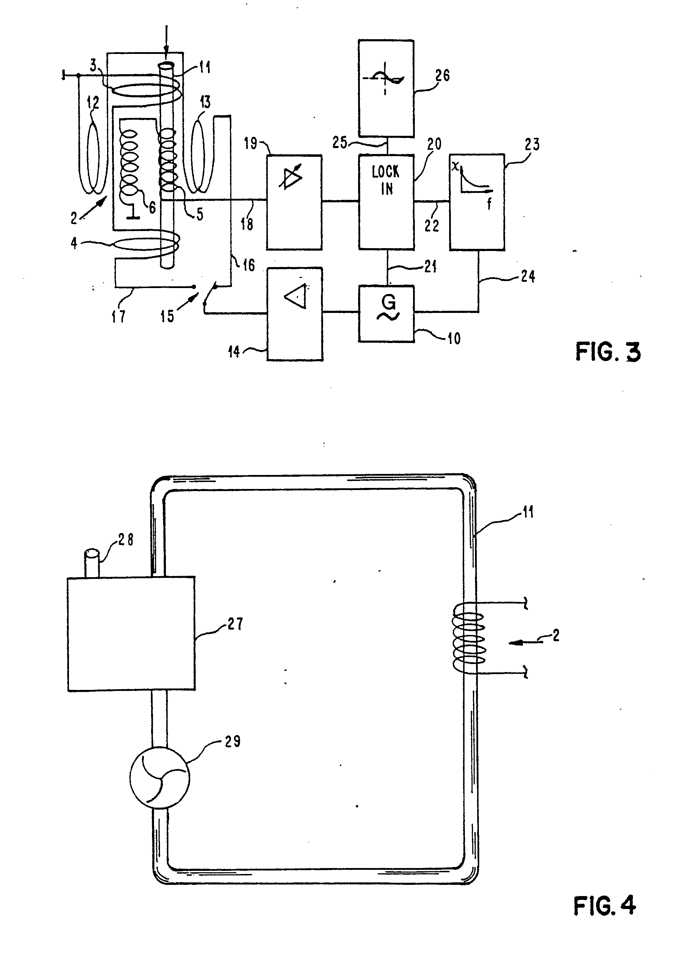

Das in der Meßspule 5 induzierte Meßsignal setzt sich aus zwei verschiedenen Anteilen zusammen: Der erste Anteil betrifft die Magnetisierungsänderung der einzelnen Teilchen. Diese Magnetisierungsänderung ist bei starr festgehaltenen Teilchenverbänden zu messen. Die Phase zwischen dem erregenden Feld und dem Meßsignal ist im betrachteten Frequenzbereich von 1 bis 100 Hz gleich Null. Der zweite Anteil ist verursacht durch die physikalische Oszillation der einzelnen Teilchen in der Viskosen Flüssigkeit. Die Phase zwischen dem induzierten Meßsignal und dem erregenden Feld ist größer als Null in dem betrachteten Frequenzbereich zwischen 1 und 100 Hz. Durch die phasenempfindliche bzw. starr gekoppelte Verstärkung in dem Lock-IN-Verstärker 20 (Fig. 3), wird zwischen den Beiden Anteilen Diskriminiert. Durch Messung des Phasenwinkels bzw. durch Benutzung des Lock-IN-Verstärkers wird die Auswertung des induzierten Signals hinsichtlich Dispersionsgrad, Viskosität und Partikeldichte aussagekräftiger.

In der in Fig. 1 gezeigten Anordnung ist die zu untersuchende Beschichtungsmasse in einem am Boden geschlossenen Gefäß untergebracht. Die Beschichtungsmasse neigt zur Sedimentation, d.h. zum Absetzen von schwereren Teilen nach unten hin. Es ist daher günstiger die Messung an in Bewegung befindlicher Beschichtungsmasse durchzuführen. Das Gefäß 1 kann dahre durch ein Rohr 11 ersetzt werden, durch das die Beschichtungsmasse hindurch geführt wird.

Ein solche Anordnung mit einem Rohr 11 ist im Zusammenhang mit einer anderen Spulenanordnung 2 in Fig. 3 dargestellt. Selbstverständlich ist es auch möglich, das in Fig. 1 gezeigte Gefäß 1 bei der dortighen Spulenanordnung 2 durch ein Rohr 11 zu ersetzen. Neben dem Spulenpaar 3 und 4 besitzt die Anordnung gemäß der Fig. 3 senkrecht dazu ein Spulenpaar mit den Spulen 12 und 13. Dieses Spulenpaar kann damit ein Magnetisches Wechselfeld veränderlicher Frequenz senkrecht zu dem magnetischen Wechselfeld variabler Frequenz der Spulen 3 und 4 erzeugen. Dazu liefert der Funktionsgenerator 10 über einen Spannungs-Stromwandler 14 und über einen Schalter 15 entweder über die Leitung 16 einen Strom an die Spulen 12 und 13 oder bei Umgeschaltetem Schalter 15 über die Leitung 17 an die Spulen 3 und 4. Die Erzeugung der Wechselfelder parallel zur Längsachse des Rohres 11 durch die Spulen 3 und 4 oder senkrecht dazu durch die Spulen 12 und 13 erfolgt demnach in diesem speziellen Ausführungsbeispiel nicht gleichzeitig sondern getrennt voneinander.

Die von den magnetischen Wechselfeldern in der Meßspule 5 induzierte Spannung wird über eine Leitung 18 einem Verstärker 19 sugeführt, dessen Verstärkungsgrad veränderlich ist. Dieser Verstärker 19 kann ein Operationsverstärker sein. Das verstärkte Signal wird einem LOCK-IN-Verstärker 20 zugeführt. Dieser Verstärker 20 erhält über Leitung 21 Signale vom Funktionsgenerator 10. Mit Hilfe dieses Refernzsignals wird sichergestellt, daß im LOCK-IN-Verstärker 20 die Verstärkung phasenstarr erfolgt, d.h. daß nur diejenigen Anteile im Signal der Meßspule 5 verstärkt werden, die derselben Frequenz des Funktionsgenerators 10 und derselben Phase jeweils entsprechen. Damit ist sichergestellt, daß nur das gewünschte Signal und keine Störsignale verarbeitet werden. Dies ist vor allem im Bereich niedriger Frequenzen nützlich. Im LOCK-IN-verstärker 20 wird das vom Verstärker 19 gelieferte Signal darüber hinaus gleich gerichtet und zeitlich integriert. Über eine Ausgangsleitung 22 wird dieses gleichgerichtete und integrierte Signal einem aufzeichnenden Schreibgerät 23 zugeführt, das die an der Ausgangsleitung 22 anstehende Spannung in Abhängigkeit der Meßfrequenz f registriert. Die Meßfrequenz f wird über eine Leitung 24 vom Funktionsgenerator 10 dem Gerät 23 zugeführt. Das Signal auf der Leitung 22, das frequenzabhängig vom Aufzeichnungsgerät dargestellt und aufgezeichnet wird, läßt sich als ein Maß für den zeitlichen Mittelwert der Magnetisierung der Suspension interpretieren.

Der LOCK-IN-Verstärker 20 ist über eine andere Leitung 25 mit einem Oszilloskopen 26 verbunden. Auf dem Oszilloskop ist damit die Darstellung des nicht integrierten Signals der Meßspule 5 möglich, das die Suszeptibilität der im Rohr 11

4

fließenden magnetischen beschichtungsmasse darstellt.

Die magnetische Beschichtungsmasse ist üblicherweise in einem Tank 27 enthalten, wie dies die Fig. 4 zeigt. Die Masse wird über ein Rohr 28 entnommen und zur Vermeidung von Sedimentation durch eine Pumpe 29 und ein Umlaufrohr 11 in Bewegung gehalten. Um dieses Rohr 11 ist die Spulenanordnung 2 angebracht.

Die magnetische Suszeptibilität der Beschichtungsmasse läßt sich mit der anordnung gemäß Fig. 3 einmal parallel zur Durchflußrichtung der Masse durch das rohr 11 messen. Dazu werden die Spulen 3 und 4 benutzt und der Schalter 15 ist in der anderen als der dargestellten Stellung, so daß der Generator 10 über die Leitung 17 diese Spulen speist.

Bei der Durchströmung des Rohres 11 richten sich die nadelförmigen Magnetteilchen parallel zur Strömungsrichtung aus. Dieser Ausrichtungsgrad ist dann besser, wenn der Dispersionsgrad der Masse hoch ist und er ist schlechter, wenn die Beschichtungsmasse viele Klumpen enthält. Werden die Teilchen einmal parallel zur Strömungsrichtung angeregt, was durch das Magnetfeld des Spulenpaares 3 und 4 erfolgt, ergibt sich ein bestimmter Wert. Erregt man die Teilchen der beschichtungsmasse senkrecht zur Strömungsrichtung, was durch das Feld der Spulen 12 und 13 erfolgt, wozu der Funktonsgenerator 10 über den wie in Fig. 3 dargestellt, eingeschalteten Schalter 15 und über die Leitung 16 diese Spulen speist, dann läßt sich wiederum ein Wert für die Magnetisierung des Beschichtungsmasse ermitteln. Aus der Differenz der Messungen Parallel und senkrecht zur Strömungsrichtung läßt sich der Ausrichtungsgrad der Beschichtungsmasse beobachten. Dieser ist wiederum ein Maß für den Dispersionsgrad, weil sich Agglomerationen bzw. Verklumpungen nicht ausrichten. Mit der Möglichkeit, die Messung so durchzuführen, daß einmal die Anregung der Magnetischen Partikel in der Beschichtungsmasse parallel zur Strömungsrichtung und einmal senkrecht dazu erfolgt, ist eine genauere Aussage über die magnetischen Eigenschaften der Beschichtungsmasse gegeben. Darüber hinaus läßt sich die messung kontinuierlich durchführen, so daß sie für eine dauernde Überwachung der Eigenschaften der Beschichtungsmasse besonders geeignet ist. Anhand dieser Messungen können Aussagen über die Verwendbarkeit der Beschichtungsmasse gemacht werden, es können ggf auch steuernde Eingriffe zur Verbesserung der Beschichtungsmasse veranlaßt werden.

Bei der messung in der Anordnung gemäß Fig. 3 oder allgemein bei der Messung von durch ein Rohr 11 strömender Beschichtungsmasse ist darauf zu achten, daß die Strömungsgeschwindigkeit höchstens so groß ist, daß ein spezielles magnetisches Partikel, welches gerade während der größten Periodendauer auf der einen Seite in das Feld eintritt noch nicht auf der anderen Seite aus dem Feld austritt. Anders ausgedrückt, muß die Strömungsgeschwindigkeit kleiner sein als die Spulenabmessung der Feldspule dividiert durch die größte Periodendauer.

## Patentansprüche

1. Anordnung zur Bestimmung der Eigenschaften von magnetischen Beschichtungsmassen, die aus einer Dispersion von Magnetpartikeln, insbesondere $\gamma$-Fe$_2$O$_3$-Pigment in einer flüssigen Harz-Lösungsmittel-Mischung, bestehen, dadurch gekennzeichnet, daß

a) die Beschichtungsmasse einem von einer Generatoranordnung (3, 4, 12, 13) enzeugtem magnetischen Wechselfeld variabler Frequenz aussetzbar ist,

b) das vom magnetischen Wechselfeld induzierte Signal durch eine Aufnehmeranordnung (5) aufnehmbar ist und

c) dis Suszeptibilität in Abhängikeit der variablen Frequenz meßbar ist und hinsichtlich Dispersionsgrad, Partikeldichte und Viskosität der Beschichtungsmasse auswertbar ist.

2. Anordnung gemäß Anspruch 1, dadurch gekennzeichnet, daß die Frequenz zwischen 1 und 100 hz variierbar ist.

3. Anordnung gemäß Anspruch 1 oder 2, dadurch gekennzeichnet, daß die Bestimmung der Eigenschaften bei möglichst geringer Feldstärke des magnetischen Wechselfelds erfolgt, wobei die Feldstärke klein genug sein soll, um eine Veränderung der magnetischen Beschichtungsmasse zu vermeiden und groß genug sein soll, um ein meßbares Signal zu erzeugen, und vorzugsweise kleiner als 10 Oe (800A/m) ist.

4. Anordnung gemäß einem der Ansprüche 1 bis 3, dadurch gekennzeichnet, daß die Beschichtungsmasse während der Bestimmung der Eigenschaften in einem rohrförmigen Teil (1, 11) enthalten ist, in dem es entweder steht oder fließt.

5. Anordnung nach einem der vorigen Ansprüche, dadurch gekennzeichnet, daß die Suszeptibilität in Abhängigkeit von der Frequenz in zwei zueinander senkrechten Richtungen, vorzugsweise parallel und senkrecht zur Längsachse des rohrförmigen Teils (1, 11), meßbar ist

6. Anordnung nach einem der vorigen Ansprüche, dadurch gekennzeichnet, daß der Phasenwinkel zwischen dem erregenden Feld und dem induzierten Signal ermittelbar ist.

7. Anordnung nach einem der vorigen Ansprüche, dadurch gekennzeichnet, daß die Generatorenanordnung ein Spulenpaar (3, 4) oder zwei zueinander senkrecht stehende, gekreuzte Spulenpaare (3, 4, und 12, 13) enthält, insbesondere Helmholtz- Spulenpaare.

8. Anordnung nach einem der vorigen Ansprüche, dadurch gekennzeichnet, daß die Generatoranordnung Spulen (3, 4, 12, 13) enthält und die Aufnehmeranordnung eine Meßspule (5) enthält, die ein die Beschichtungsmasse enthaltendes rohrförmiges Teil (1, 11) umgeben.

9. Anordnung nach einem der vorigen Ansprüche, dadurch gekennzeichnet, daß zur eliminierenden Kompensation des erregenden magnetischen Wechselfeldes im Meßsignal eine zu einer Meßspule (5) der Aufnehmeranordnung mechanisch und elektrisch identische Kompensationsspule (6) vorgesehen ist, die nicht von einem rohrförmigen Teil und nicht von einer Beschichtungsmasse durchsetzt ist und elektrisch kompensierend geschaltet ist.

10. Anordnung nach einem der vorigen Ansprüche, dadurch gekennzeichnet, daß das erregende magnetische Wechselfeld von einem Funktionsgenerator (10) steuerbar ist, und das von einer Meßspule (5) der Aufnehmeranordnung aufgenommene induzierte Signal in einem phasengekoppelten Verstärker (20), der frequenzstarr an den Funktionsgenerator (10) gekoppelt ist, integrierbar ist und das integrierbar Signal auf einem aufzeichnenden Meßgerät (23) in Abhängigkeit von der Frequenz registrierbar ist.

## Revendications

1. Agencement pour déterminer les propriétés de masses d'enduction magnétiques, constituées par une dispersion de particules magnétiques, notamment des pigments de $Fe_2O_3$-$\gamma$ dans un mélange liquide résine-solvant, cet agencement étant caractérisé par le fait que

a) la masse d'enduction peut être exposée à un champ magnétique alternatif à fréquence variable engendré par un agencement générateur (3, 4, 12, 13),

b) le signal induit par le champ magnétique alternatif peut être reçu par un agencement récepteur (5), et

c) la susceptibilité peut être mesurée en fonction de la fréquence variable et être interprétée du point du vue du degré de dispersion, de la densité des particules et de la viscosité de la masse d'enduction.

2. Agencement selon la revendication 1, caractérisé par le fait que la fréquence peut être modifiée entre 1 et 100 Hz.

3. Agencement selon la revendication 1 ou 2, caractérisé par le fait que la détermination des propriétés est effectuée en présence d'une intensité aussi faible que possible du champ magnétique alternatif, l'intensité de champ devant être suffisamment petite pour éviter une modification de la masse d'enduction magnétique, et devant être suffisamment grande pour engendrer un signal mesurable, et étant de préférence plus petite que 10 Oe (800 A/m).

4. Agencement selon l'une des revendications 1 à 3, caractérisé par le fait que, pendant la détermination des propriétés, la masse d'enduction est contenue dans une pièce tubulaire (1, 11) dans laquelle elle est soit stationnaire soit en écoulement.

5. Agencement selon l'une des revendications précédentes, caractérisé par le fait que la susceptibilité est mesurable en fonction de la fréquence, dans deux directions orthogonales, de préférence parallèlement et perpendiculairement à l'axe longitudinal de la pièce tubulaire (1, 11).

6. Agencement selon l'une des revendications précédentes, caractérisé par le fait que l'on peut déterminer l'angle de phase entre le champ excitateur et le signal induit.

7. Agencement selon l'une des revendications précédentes, caractérisé en ce que l'agencement générateur comporte une paire de bobines (3, 4) où deux couples de bobines (3, 4 et 12, 13) qui sont croisés et sont orthogonaux, notamment des paires de bobines de Helmholtz.

8. Agencement selon l'une des revendications précédentes, caractérisé par le fait que l'agencement générateur comporte des bobines (3, 4, 12, 13) et l'agencement récepteur comporte und bobine de mesure (5), lesquelles entourent une pièce tubulaire (1, 11) contenant la masse d'enduction.

9. Agencement selon l'une des revendications précédentes, caractérisé par le fait que, pour la compensation d'élimination du champ magnétique excitateur dans le signal de mesure, il est prévu une bobine de compensation (6) mécaniquement et électriquement identique à une bobine de mesure (5) de l'agencement récepteur, cette bobine de compensation n'étant traversée ni par une pièce tubulaire ni par de la masse d'enduction, et étant électriquement montée pour être compensatrice.

10. Agencement selon l'une des revendications précédentes, caractérisé par le fait que le champ magnétique alternatif excitateur peut être commandé par un générateur de fonctions (10) et par le fait que le signal induit capté par une bobine de mesure (5) de l'agencement récepteur peut être intégré dans un amplificateur à couplage de phase (20) qui est couplé rigidement en fréquence au générateur de fonctions (10), et en ce que le signal pouvant être intégré peut être enregistré sur un appareil de mesure enregistreur (23), en fonction de la fréquence.

## Claims

1. Arrangement for characterizing magnetic coating compositions consisting of a dispersion of magnetic paricles, particularly $\gamma$-$Fe_2O_3$ pigment in a fluid resin solvent mixture, characterized in that

a) the coating composition is exposable to an alternating magnetic field of variable frequency produced by a generator arrangement (3, 4, 12, 13),

b) the signal induced by the alternating magnetic field is receivable by a receiver arrangement (5),

c) the susceptibility is measurable as a function of the variable frequency and evaluatable with respect to degree of dispersion, particle density, and viscosity of the coating composition.

2. Arrangement as claimed in claim 1, characterized in that the frequency is variable between 1 and 100 cps.

3. Arrangement as claimed in claim 1 or 2, characterized in that the properties are defined at a minimum field intensity of the alternating magnetic field, with the field intensity being sufficiently low to prevent a change of the magnetic coating composition, and sufficiently high to generate a measurable signal, and preferably lower than 10 Oerstedt (800 A/m).

4. Arrangement as claimed in any one of claims 1 to 3, characterized in that during the defining of the properties the coating composition is contained in a pipe-shaped part (1, 11) where it is either stagnant or fluid.

5. Arrangement as claimed in any one of the preceding claims, characterized in that the susceptibility is measurable as a function of the frequency in two directions vertical to each other, preferably in parallel and vertical to the longitudinal axis of the pipe-shaped part (1, 11).

6. Arrangement as claimed in any one of the preceding claims, characterized in that the phase angle between the energizing field and the induced signal can be determined.

7. Arrangement as claimed in any one of the preceding claims, characterized in that the generator arrangement comprises a pair of coils (3, 4) or two crossed coil pairs (3, 4 and 12, 13) arranged vertically to each other, in particular pairs of Helmholtz coils.

8. Arrangement as claimed in any one of the preceding claims, characterized in that the generator arrangement contains coils (3, 4, 12, 13), and the receiver arrangement contains a measuring coil (5) which surrounds a pipe-shaped part (1, 11) containing the coating composition.

9. Arrangement as claimed in any one of the preceding claims, characterized in that for the eliminating compensation of the energizing alternating magnetic field in the measuring signal a compensating coil (6) identical mechanically and electrically with a measuring coil (5) of the receiver arrangement is provided which does not surround a pipe-shaped part and does not contain a coating composition, and which is connected in an electrically compensating mode.

10. Arrangement as claimed in any one of the preceding claims, characterized in that the energizing alternating magnetic field is controllable by a function generator (10), and that the induced signal received by a measuring coil (5) of the receiver arrangement is integratable in a phase-coupled amplifier (20) which in a frequency locked mode is coupled to the function generator (10), and that the integratable signal is registerable on a recorder (23) as a function of the frequency.

FIG. 1

FIG. 2

FIG. 3

FIG. 4